# EUROPEAN PATENT SPECIFICATION

(11) **EP 4 697 872 B1**
(45) Date of publication and mention of the grant of the patent: **26.08.2026**
(21) Application number: 25191513.8
(22) Date of filing: 24.07.2025
(51) Int. Cl.: H05K 5/15, H05K 5/02

(54) **COVER ASSEMBLY STRUCTURE**
ABDECKUNGSANORDNUNGSSTRUKTUR
STRUCTURE D'ENSEMBLE COUVERCLE

(30) Priority: 14.08.2024 JP 2024135202
(43) Date of publication of application: 18.02.2026
(73) Proprietor: Yazaki Corporation, Tokyo 108-0075 (JP)
(72) Inventor: Nagata, Daiki, Kakegawa-shi, Shizuoka, 437-1421 (JP); Hashimoto, Yuki, Kakegawa-shi, Shizuoka, 437-1421 (JP)
(74) Representative: Grünecker Patent- und Rechtsanwälte PartG mbB

(56) References cited:
- WO-A1-2009/118936
- JP-A- 2013 002 637
- US-B2- 9 175 714

## Description

### BACKGROUND OF THE INVENTION

### 1. Field of the Invention

The present invention relates to a cover assembly structure.

### 2. Description of the Related Art

Conventionally, a cover covers an opening of an internal space of a housing and is assembled to the housing at the position. For example, JP 2021 - 187 573 A discloses a cover assembly structure including the cover and a housing, and the cover is screwed and secured to the housing.

Meanwhile, as a cover assembling structure, there is a cover assembly structure including a cover, a housing, and a clip, and the cover and the housing are assembled by the clip inserted in a through hole of a flat plate of the cover and a through hole of a flat plate of the housing. The clip includes a shaft inserted in the respective through holes of the flat plates superposed on each other, a first locker that locks the flat plates from the side of location of the cover, and a second locker that locks the flat plates from the side of location of the housing. In this cover assembly structure, the second locker passes through the through holes while bending, whereby a peripheral portion of the through hole of the flat plate of the cover and a peripheral portion of the through hole of the flat plate of the housing are clipped between the first locker and the second locker. Thus, in the clip, in consideration of its attachment workability and others, for example, the interval between the first locker and the second locker is larger than the total value of the respective plate thicknesses of the superposed flat plates to have play corresponding to the difference. In the cover assembly structure, in order to suppress rattling of the cover in its removal direction due to the play, a cover locker that locks a movement of the cover in its removal direction may be provided. In the conventional cover assembly structure, even if the flat plates are not superposed on each other at the proper position due to, for example, the cover being caught by the cover locker, the attachment of the clip may be finished even though the cover is in a defective assembly state due to the play described above or deformation of the cover made of synthetic resin.
Document WO 2009/118936 A1 discloses a cover assembly structure according to the preamble part of claim 1.

### SUMMARY OF THE INVENTION

Therefore, an object of the present invention is to provide a cover assembly structure that enables prevention of defective assembly of a cover.

In order to achieve the above mentioned object, a cover assembly structure according to one aspect of the present invention includes a cover; a housing to which the cover is assembled; a clip that holds the cover and the housing at an assembly complete position; and a cover locker that locks the cover at the assembly complete position, wherein the clip includes: a shaft inserted in a through hole of a flat plate of the cover and a through hole of a flat plate of the housing with the flat plates superposed on each other at the assembly complete position; a first locker that locks a peripheral portion of the through hole of the flat plate of the cover, the first locker being provided to an end of the shaft; and a second locker that locks a peripheral portion of the through hole of the flat plate of the housing at a position where the second locker is located out of the through hole of the flat plate of the housing the second locker is configured to pass through the through hole while bending, the second locker being provided to another end of the shaft, the cover includes a locking target locked by the cover locker at the assembly complete position against a movement in a direction opposite to an insertion direction of the second locker with respect to the through holes, and the cover locker includes an abutment that abuts on the locking target due to approach of the locking target in the insertion direction to prevent defective assembly of the cover.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

FIG. 1 is a view illustrating a cover assembly structure according to an embodiment, and illustrates a cover in a proper assembly state; and
FIG. 2 is a view illustrating the cover assembly structure of the embodiment, and illustrates the cover in a defective assembly state.

### DETAILED DESCRIPTION OF THE PREFERRED EMBODIMENTS

Hereinafter, embodiments of a cover assembly structure according to the present invention will be described in detail with reference to the drawings. Note that the present invention is not limited to the embodiments.

### Embodiment

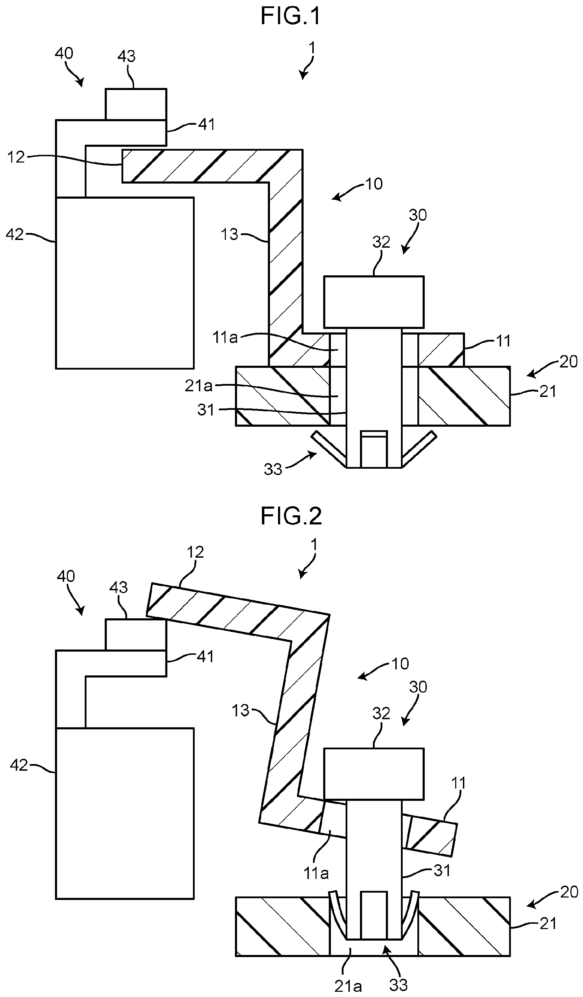

An embodiment of a cover assembly structure according to the present invention will be described with reference to FIGS. 1 and 2.

Reference numeral 1 in FIGS. 1 and 2 denotes the cover assembly structure of the present embodiment. A cover assembly structure 1 includes a cover 10, a housing 20 to which the cover 10 is assembled, and a clip 30 that holds the cover 10 and the housing 20 at an assembly complete position. The cover assembly structure 1 further includes a cover locker 41 that locks the cover 10 at the assembly complete position.

The cover 10 is formed of a synthetic resin material. The cover 10 includes a flat plate 11 at a holding position with respect to the housing 20 (FIGS. 1 and 2). The flat plate 11 has a through hole 11a through which the clip 30 is inserted.

The housing 20 is formed of a synthetic resin material. Although not illustrated, the housing 20 has an internal space for accommodating an accommodation target, and an opening of the internal space is closed by the cover 10. The housing 20 includes a flat plate 21 at a holding position with respect to the cover 10 (FIGS. 1 and 2). The flat plate 21 has a through hole 21a through which the clip 30 is inserted.

With the flat plates 11 and 21 superposed on each other at the assembly complete position, the clip 30 is inserted in the through holes 11a and 21a coaxially disposed, whereby the cover 10 and the housing 20 are held by the clip 30 (FIGS. 1 and 2). The clip 30 illustrated here is formed of a synthetic resin material.

The clip 30 includes a shaft 31 inserted in the through hole 11a of the flat plate 11 of the cover 10 and the through hole 21a of the flat plate 21 of the housing 20 with the flat plates 11 and 21 superposed on each other at the assembly complete position, a first locker 32 that locks the flat plates 11 and 21 from the side of location of the cover 10, and a second locker 33 that locks the flat plates 11 and 21 from the side of location of the housing 20 (FIGS. 1 and 2). The first locker 32 is provided to an end of the shaft 31, and locks a peripheral portion of the through hole 11a of the flat plate 11 of the cover 10. The second locker 33 is provided to another end of the shaft 31, and locks a peripheral portion of the through hole 21a of the flat plate 21 of the housing 20 at a position where the second locker 33 is located out of the through hole 21a of the flat plate 21 of the housing 20 in a case where the second locker 33 passes through the through holes 11a and 21a while bending.

The clip 30 clips the flat plates 11 and 21 superposed on each other at the assembly complete position between the first locker 32 and the second locker 33 (FIGS. 1 and 2). The clip 30 is formed of a synthetic resin material, and in view of, for example, a large difference between the tolerance and variation, in order to facilitate and ensure the attachment work, the interval between the first locker 32 and the second locker 33 is larger than the total value of the respective plate thicknesses of the superposed flat plates 11 and 21 to have play corresponding to the difference. Therefore, the cover 10 may cause rattling with the housing 20, and accordingly, an unnecessary overload may be applied to the clip 30 by the load applied to the second locker 33. In order to prevent such an application, the cover assembly structure 1 includes a cover locker 41.

The cover locker 41 locks the cover 10 so that the cover 10 is not detached from the housing 20 in the axial direction of the shaft 31 of the clip 30 when the cover 10 is at the assembly complete position (FIG. 1). Therefore, the cover 10 includes a locking target 12 locked by the cover locker 41 at the assembly complete position against a movement in the direction opposite to the insertion direction of the second locker 33 with respect to the through holes 11a and 21a (FIG. 1). The cover 10 has a protrusion 13 protruding from the flat plate 11 in the direction opposite to the insertion direction, and the locking target 12 is provided to the leading end of the protrusion 13 on the side in the direction in which the protrusion 13 protrudes. The locking target 12 illustrated here protrudes from the leading end of the protrusion 13 in a direction orthogonal to the insertion direction of the second locker 33.

Here, the cover locker 41 may be provided to the housing 20 or may be provided to an installation member installed without displacement with respect to the housing 20. For example, here, another housing 40 is installed and secured on a member (not illustrated) on which the housing 20 is installed and secured, and the other housing 40 serves as an installation member installed without displacement with respect to the housing 20 (FIGS. 1 and 2). Therefore, here, the cover locker 41 is provided to the other housing 40. The cover locker 41 illustrated here is disposed with a gap in the axial direction of the shaft 31 of the clip 30 with respect to a box body 42 of the other housing 40, and locks the locking target 12 of the cover 10 inserted in the gap between the box body 42 and the cover locker 41 (FIG. 1).

In the cover assembly structure 1, after the housing 20 and the other housing 40 are installed and secured on the same member, the cover 10 is installed on the housing 20 while the locking target 12 is inserted into the gap between the box body 42 and the cover locker 41, and the flat plates 11 and 21 are superposed on each other with the through holes 11a and 21a coaxially disposed. In the cover assembly structure 1, the clip 30 is inserted in the through holes 11a and 21a in this state, and the flat plates 11 and 21 are clipped between the first locker 32 and the second locker 33 of the clip 30 (FIG. 1).

However, in a case where the flat plates 11 and 21 are to be superposed on each other without insertion of the locking target 12 into the gap between the box body 42 and the cover locker 41, the locking target 12 is caught by the cover locker 41 that leads to a defective assembly state of the cover 10 (FIG. 2). In the cover assembly structure 1, a countermeasure is taken with the cover locker 41 so that the attachment of the clip 30 is not complete in the defective assembly state of the cover 10. The cover locker 41 includes an abutment 43 that abuts on the locking target 12 due to approach of the locking target 12 in the insertion direction of the second locker 33 into the through holes 11a and 21a to prevent defective assembly of the cover 10 (FIGS. 1 and 2). The abutment 43 is a protrusion protruding from the cover locker 41 in a direction opposite to the insertion direction of the second locker 33, and abuts on the locking target 12 before the second locker 33 is located out of the through holes 11a and 21a (FIG. 2). With this arrangement, in the cover assembly structure 1, even if the clip 30 is inserted into the through holes 11a and 21a when the cover 10 is in a defective assembly state, the second locker 33 cannot be located out of the through hole 21a of the housing 20, and thus the attachment of the clip 30 cannot be complete (FIG. 2). Therefore, the cover assembly structure 1 can prevent defective assembly of the cover 10.

In the cover assembly structure according to the present embodiment, even if a clip is inserted into a through hole when the cover is in a defective assembly state, a second locker cannot be located out of a through hole of a housing, so that the attachment of the clip cannot be complete. Therefore, the cover assembly structure according to the present invention can prevent defective assembly of the cover.

## Claims

1. A cover assembly structure (1) comprising:
a cover (10);
a housing (20) to which the cover (10) is assembled;
a clip (30) that holds the cover (10) and the housing (20) at an assembly complete position;
**characterized in**
a cover locker (41) that locks the cover (10) at the assembly complete position, wherein
the clip (30) includes: a shaft (31) inserted in a through hole (11a) of a flat plate (11) of the cover (10) and a through hole (21a) of a flat plate (21) of the housing (20) with the flat plates (11, 21) superposed on each other at the assembly complete position; a first locker (32) that locks a peripheral portion of the through hole (11a) of the flat plate (11) of the cover (10), the first locker (32) being provided to an end of the shaft (31); and a second locker (33) that locks a peripheral portion of the through hole (21a) of the flat plate (21) of the housing (20) at a position where the second locker (33) is located out of the through hole (21a) of the flat plate (21) of the housing (20), the second locker (33) is configured to pass through the through hole (11a, 21a) while bending, the second locker (33) being provided to another end of the shaft (31),
the cover (10) includes a locking target (12) locked by the cover locker (41) at the assembly complete position against a movement in a direction opposite to an insertion direction of the second locker (33) with respect to the through holes (11a, 21a), and
the cover locker (41) includes an abutment (43) that abuts on the locking target (12) due to approach of the locking target (12) in the insertion direction to prevent defective assembly of the cover (10).

2. The cover assembly structure (1) according to claim 1, wherein
the abutment (43) abuts on the locking target (12) before the second locker (33) is located out of the through holes (11a, 21a).

3. The cover assembly structure (1) according to claim 1 or 2, further comprising:
an installation member (40) installed without displacement with respect to the housing (20), wherein
the cover locker (41) is provided to the housing (20) or the installation member (40).

## Patentansprüche

1. Eine Abdeckanordnungsstruktur (1), aufweisend:
eine Abdeckung (10);
ein Gehäuse (20), an dem die Abdeckung (10) montiert ist;
eine Klammer (30), die die Abdeckung (10) und das Gehäuse (20) in einer Montageendposition hält;
**gekennzeichnet durch**
eine Abdeckungsverriegelung (41), die die Abdeckung (10) in der Montageendposition verriegelt, wobei
die Klammer (30) aufweist: einen Schaft (31), der in ein Durchgangsloch (11a) einer flachen Platte (11) der Abdeckung (10) und in ein Durchgangsloch (21a) einer flachen Platte (21) des Gehäuses (20) eingesetzt ist, wobei die flachen Platten (11, 21) in der Montageendposition übereinanderliegen; ein erste Verriegelung (32), die einen Randabschnitt des Durchgangslochs (11a) der flachen Platte (11) der Abdeckung (10) verriegelt, wobei das erste Verriegelung (32) an einem Ende des Schafts (31) vorgesehen ist; und eine zweite Verriegelung (33), die einen Abschnitt des Durchgangslochs (21a) der flachen Platte (21) des Gehäuses (20) an einer Position verriegelt, an der sich die zweite Verriegelung (33) außerhalb des Durchgangslochs (21a) der flachen Platte (21) des Gehäuses (20) befindet, wobei die zweite Verriegelung (33) so ausgebildet ist, dass sie unter Biegung durch das Durchgangsloch (11a, 21a) hindurchgeführt werden kann, wobei die zweite Verriegelung (33) an einem anderen Ende des Schafts (31) vorgesehen ist,
die Abdeckung (10) ein Verriegelungsziel (12) aufweist, das in der Endmontageposition durch die Abdeckungsverriegelung (41) gegen eine Bewegung in einer Richtung verriegelt wird, die der Einführungsrichtung der zweiten Verriegelung (33) in Bezug auf die Durchgangslöcher (11a, 21a) arretiert wird, und
die Abdeckungsverriegelung (41) einen Anschlag (43) aufweist, der aufgrund der Annäherung des Verriegelungsziels (12) in der Einführungsrichtung an das Verriegelungsziel (12) anliegt, um eine fehlerhafte Montage der Abdeckung (10) zu verhindern.

2. Die Abdeckanordnungsstruktur (1) nach Anspruch 1, wobei
der Anschlag (43) an dem Verriegelungsziel (12) anliegt, bevor sich das zweite Verriegelung (33) außerhalb der Durchgangslöcher (11a, 21a) befindet.

3. Die Abdeckanordnungsstruktur (1) nach Anspruch 1 oder 2, weiter aufweisend:
ein Einbauelement (40), das ohne Verschiebung in Bezug auf das Gehäuse (20) eingebaut ist, wobei die Abdeckungsverriegelung (41) am Gehäuse (20) oder am Einbauelement (40) vorgesehen ist.

## Revendications

1. Structure d'assemblage de couvercle (1) comprenant :
un couvercle (10) ;
un boîtier (20) sur lequel le couvercle (10) est assemblé ;
un clip (30) qui maintient le couvercle (10) et le boîtier (20) dans une position d'assemblage complet ;
**caractérisée par**
un dispositif de verrouillage de couvercle (41) qui verrouille le couvercle (10) dans la position d'assemblage complet, dans laquelle
le clip (30) inclut : un axe (31) inséré dans un trou traversant (11a) d'une plaque plane (11) du couvercle (10) et un trou traversant (21a) d'une plaque plane (21) du boîtier (20), les plaques plates (11, 21) étant superposées dans la position d'assemblage complet ; un premier dispositif de verrouillage (32) qui verrouille une portion périphérique du trou traversant (11a) de la plaque plane (11) du couvercle (10), le premier dispositif de verrouillage (32) étant pourvu à une extrémité de l'axe (31) ; et un deuxième dispositif de verrouillage (33) qui verrouille une portion périphérique du trou traversant (21a) de la plaque plane (21) du boîtier (20) dans une position où le deuxième dispositif de verrouillage (33) est situé hors du trou traversant (21a) de la plaque plane (21) du boîtier (20), le deuxième dispositif de verrouillage (33) étant configuré pour passer à travers le trou traversant (11a, 21a) tout en se pliant, le deuxième dispositif de verrouillage (33) étant pourvu à une autre extrémité de l'axe (31),
le couvercle (10) inclut une cible de verrouillage (12) verrouillée par le dispositif de verrouillage de couvercle (41) dans la position d'assemblage complet contre un mouvement dans une direction opposée à la direction d'insertion du deuxième dispositif de verrouillage (33) par rapport aux trous traversants (11a, 21a), et
le dispositif de verrouillage de couvercle (41) inclut une butée (43) qui bute contre la cible de verrouillage (12) en raison de l'approche de la cible de verrouillage (12) dans la direction d'insertion pour empêcher un assemblage défectueux du couvercle (10).

2. Structure d'assemblage de couvercle (1) selon la revendication 1, dans laquelle
la butée (43) bute contre la cible de verrouillage (12) avant que le deuxième dispositif de verrouillage (33) ne soit hors des trous traversants (11a, 21a).

3. Structure d'assemblage de couvercle (1) selon la revendication 1 ou 2, comprenant en outre :
un élément d'installation (40) installé sans déplacement par rapport au boîtier (20), dans laquelle
le couvercle du dispositif de verrouillage (41) est pourvu sur le boîtier (20) ou sur l'élément d'installation (40).
